# FASCICULE DE BREVET EUROPEEN

(11) **EP 0 788 202 B1**
(45) Date de publication et mention de la délivrance du brevet: **27.12.2000**
(21) Numéro de dépôt: 97400192.7
(22) Date de dépôt: 28.01.1997
(51) Int. Cl.: H01S 5/10, H01S 5/32

(54) **Composant d'émission laser à zone d'injection de largeur limitée**
Bauteil für Laseremission mit einer Injektionszone begrenzter Breite
Laser emission component with injection zone of limited width

(30) Priorité: 30.01.1996 FR 9601057
(43) Date de publication de la demande: 06.08.1997
(73) Titulaire: FRANCE TELECOM, 75015 Paris (FR)
(72) Inventeur: Nabet, Bernard, 75014 Paris (FR); Bouley, Jean-Claude, 94110 Arcueil (FR); Bouadma, Nordine, 94250 Gentilly (FR)
(74) Mandataire: Martin, Jean-Jacques

(56) Documents cités:
- US-A- 5 343 487
- US-A- 5 493 577
- IEEE PHOTONICS TECHNOLOGY LETTERS, vol. 7, no. 9, 1 Septembre 1995, pages 968-970, XP000527492 ROCHUS S ET AL: "Submilliamp vertical-cavity surface-emitting lasers with buried lateral-current confinement"
- ELECTRONICS LETTERS, vol. 31, no. 11, 25 Mai 1995, pages 886-888, XP000519105 YANG G M ET AL: "Ultralow threshold current vertical-cavity surface-emitting lasers obtained with selective oxidation"
- JAPANESE JOURNAL OF APPLIED PHYSICS, vol. 32, no. 3A, PART 01, 1 Mars 1993, page 1126/1127 XP000415017 TOSHIHIKO BABA ET AL: "A low-threshold 1.3um GaInAsP/InP flat-surface circular buried heterostructure surface emitting laser"
- OPTICAL AND QUANTUM ELECTRONICS, vol. 18, no. 6, Novembre 1986, pages 403-422, XP000603579 K.IGA, S.UCHIYAMA: "GaInAsP/InP surface emitting laser diode"
- APPLIED PHYSICS LETTERS, vol. 60, no. 24, 15 Juin 1992, pages 2974-2976, XP000269914 HIROSHI WADA ET AL: "Effects of nonuniform current injection in GaInAsP/InP vertical-cavity lasers"
- IEEE PHOTONICS TECHNOLOGY LETTERS, vol. 7, no. 5, 1 Mai 1995, pages 444-446, XP000506775 CHUA C L ET AL: "Low-threshold 1.57-um VC-SEL's usimg strain-compensated quantum wells and oxide/metal backmirror"

## Description

L'invention concerne les composants d'émission laser à cavité verticale émettant par la surface, et les procédés de fabrication de ces composants.

Les composants d'émission laser à émission par la surface (VCSEL) offrent de nombreux avantages par rapport aux composants d'émission lasers à émission par la tranche : possibilité de très faible courant de seuil, intégration bidimensionnelle, couplage plus simple avec une fibre optique, triage des puces sur plaques,...

Cependant, jusqu'à présent, aucun composant n'a été capable d'émettre de façon continue à température ambiante inférieure à 30°C, aux longueurs d'onde des communications optiques (1,3 ou 1,55 µm). La raison en est que les composants existants présentent un courant de seuil encore trop élevé dû à la mauvaise qualité de l'injection du courant dans le milieu actif.

On recense deux paramètres caractérisant la qualité de l'injection du courant :
- la surface de la zone d'injection des porteurs ; et
- la forme de la répartition des porteurs injectés dans cette zone.

Pour le premier paramètre, on cherche à localiser l'injection du courant dans une zone bien précise à l'intérieur du matériau actif, en limitant au maximum toute fuite du courant hors du matériau actif ou latéralement hors de la zone d'injection définie.

Pour définir la zone d'injection des porteurs, et ainsi obtenir le confinement du courant injecté, deux méthodes sont couramment employées. La première consiste à définir un canal pour le passage du courant dans le semiconducteur dopé p allant des contacts à la zone active en réalisant une barrière circulaire (formant des barrières latérales en coupe) s'opposant au passage du courant (par exemple des zones implantées à très grande résistance ou matériau isolant...) :
voir Jack L. Jewell, J.P. Harbison, A. Scherer, Y.JL Lee, and L.T. Florez : "Vertical-Cavity Surface-Emitting Lasers : Design, Growth, Fabrication, Characterization", IEEE J. Quantum Electron. Vol 27, No 6, p 1332, June 1991 ;
voir D.L. Huffaker, D.G. Deppe, K. Kumar, and T.J. Rogers : "Native-Oxide defined ring contact for low threshold vertical-cavity lasers", Appl. Phys. Lett. 65(1), p 97, July 1994 ;
voir R. Michalzik end K.J. Ebeling : "Modeling and Design of Proton-Implanted Ultralow-Threshold Vertical-Cavity Laser Diodes", IEEE J. Quantum Electron. Vol 29, No 6, p 1963, June 1993.

Cependant, le confinement du courant n'est pas très efficace et l'on obtient d'importantes fuites latérales dans le milieu actif, la zone d'injection des porteurs ne pouvant être définie précisément.

La seconde méthode consiste à graver la zone active pour réaliser une zone active enterrée de largeur finie c'est-à-dire de largeur inférieure à la largeur du composant, empêchant ainsi toute fuite latérale du courant, la zone active étant éventuellement entourée de couches bloquantes (de type pnpn) :
voir K. Iga, S. Uchiyama : "GaInAsP/InP surface-emitting laser diode", Optical and Quantum Electron. 18 (1986), p 403 ;
voir T. Baba, Y. Yogo, K. Suzuki, F. Koyama, and K. Iga : "Surface-Emitting Lasers of Low-Threshold 1.3 µm GaInAsp/InP Circular Planar-Buried heterostructure", Electron. and Commun. in Japan, Part2, Vol 77, No 2, p 29, 1994.

Cependant, dans les deux cas, il est difficile d'obtenir satisfaction sur le second paramètre, à savoir la répartition des porteurs injectés.

Pour le second paramètre, il faut que la répartition radiale de la densité de porteurs injectés (n) dans cette zone, qui détermine la distribution radiale du gain (g) (puisque g = A(n-n₀) en première approximation), procure le meilleur gain modal possible (intégrale de recouvrement entre les distributions radiales du mode optique fondamental et du gain fourni par l'injection des porteurs). En d'autres termes, cela signifie qu'il faut injecter des porteurs et donc rendre le matériau actif amplificateur là où se trouve le champ électromagnétique.

Or, dans le système InP, l'impossibilité de réaliser de bons miroirs de Bragg en semiconducteur InP dopé p, impose la réalisation de miroirs en diélectrique et donc la prise des contacts du courant sur les côtés. De même, pour la filière GaAs l'utilisation de structures comportant un miroir diélectrique à la place du miroir de Bragg semiconducteur dopé p présentant une résistance série beaucoup trop grande, est de plus en plus fréquente.

Les contacts se retrouvent donc déportés sur les côtés par rapport à la zone d'injection, ce qui entraîne une forte variation de la distribution radiale du potentiel dans la structure et pose de nouveaux problèmes : la jonction p-zone active-n se retrouve fortement polarisée sur les côtés de la zone d'injection et beaucoup moins polarisée au centre de cette zone. La densité de porteurs injectés est donc grande sur les côtés, et plus faible au centre (parfois de façon très significative). Il en est donc de même de la distribution radiale du gain et le gain modal du mode transverse fondamental est loin d'être optimisé :
voir JJ. Wada, K.I. Babic, M. Ishikawa, and J.E. Bowers : "Effects of nonuniform current injection in GaInAsP/Inp vertical cavity lasers", Appl. Phys. Lett. 60(24), p 2974, June 1992 ;
voir J.W. Scott, R.S. Geels, S.W. Corzine, and L.A. Goldren : "Modelling temperature effects and spatial hole burning to optimize vertical cavity surface emitting laser performance", IEEE J. Quantum Electron., Vol 29, No 5, p 1295, 1993.

Aucune méthode efficace n'a jamais été vraiment proposée pour annuler cet effet si ce n'est le remplacement de la couche p par deux couches : une couche p++ diffusant les porteurs vers le centre et une couche p-résistive (pas trop grande car elle élève Rs) empêchant les porteurs de retourner vers le centre. Au mieux l'injection obtenue est presque uniforme mais jamais concentrée au centre.

Un but de l'invention est de réaliser un composant dans lequel la zone d'injection du courant soit bien délimitée et la répartition radiale des porteurs soit telle que la densité de porteurs est plus forte au centre que sur les côtés. L'invention a également pour but de fournir un composant présentant un gain modal supérieur à celui des composants précités et un courant de seuil réduit en vue notamment de pouvoir émettre à température ambiante inférieure à 30°C à λ = 1,3 ou 1,55 µm.

En vue de la réalisation de ce but, on prévoit selon l'invention un composant d'émission laser à cavité verticale émettant par la surface à une longueur d'onde comprise entre 1,3 et 1,55 µm, comportant une couche de matériau actif présentant une zone d'injection de largeur inférieure à la largeur du composant, cette zone émettant un rayonnement lors de l'injection d'un courant électrique, le composant comportant en outre un milieu amplificateur du rayonnement et deux miroirs réfléchissant à la longueur d'onde d'émission et disposés respectivement au-dessus et au-dessous du milieu amplificateur, dans lequel le milieu amplificateur comporte une barrière circulaire s'étendant en regard du matériau actif, cette barrière s'opposant au passage du courant et délimitant en son centre en regard de la zone d'injection un canal de passage du courant, ce canal ayant une largeur inférieure à la largeur de la zone d'injection.

La combinaison de la zone d'injection de largeur limitée avec le canal de passage du courant défini par la barrière circulaire en regard dans le semi-conducteur dopé p, réalise le confinement de l'injection et amène les porteurs au centre de la zone active. La jonction p -zone active- n se retrouve ainsi plus fortement polarisée au centre que sur les côtés de la zone d'injection, ce qui est l'inverse de ce qui se produisait dans les composants connus précités. La densité de porteurs dans la zone active est bien supérieure au centre que sur les côtés. Il en résulte un gain modal bien meilleur que dans les composants connus précités. Ce résultat peut être modulé en variant la largeur du canal de passage défini par la barrière circulaire et la largeur de la zone d'injection. Le composant selon l'invention réalise un confinement efficace de l'injection et une bonne répartition des porteurs injectés. Il permet ainsi de réduire le courant de seuil et rend possible d'émettre à température ambiante inférieure à 30°C à λ = 1,3 ou 1,55 µm. Le composant selon l'invention réalise un double confinement électronique.

Par exemple, pour une zone active de largeur égale à 0,88 µm, le composant selon l'invention permet d'obtenir un courant de seuil d'environ 75 mA pour une réflectivité de 0,95 aux extrémités de la zone active, et de 15 mA pour une réflectivité de 0,99, alors que les composants classiques ont un courant de seuil d'environ 155 mA et d'environ 30 mA dans les mêmes conditions.

On prévoit également selon l'invention plusieurs procédés de fabrication du composant selon l'invention.

D'autres caractéristiques et avantages de l'invention apparaîtront encore à la lecture de la description qui va suivre de six modes de réalisation de l'invention donnés à titre d'exemples non limitatifs.

Aux dessins annexés :
- la figure 1a est une vue en coupe d'un composant selon un premier mode de réalisation de l'invention ;
- la figure 1b est une vue en coupe d'un composant selon une variante de ce premier mode de réalisation ;
- la figure 2 est une vue en coupe d'un composant selon un deuxième mode de réalisation ;
- la figure 3 est une vue en coupe d'un composant selon un troisième mode de réalisation ;
- la figure 4 est une vue en coupe d'un composant selon un quatrième mode de réalisation ;
- la figure 5 est une vue en coupe d'un composant selon un cinquième mode de réalisation ; et
- la figure 6 est une vue en coupe d'un composant selon un sixième mode de réalisation de l'invention.

Les six modes de réalisation de l'invention décrits ci-après sont des composants d'émission lasers à cavité verticale émettant par la surface à une longueur d'onde λ comprise entre 1,3 et 1,55 µm. Ces composants sont fabriqués au moyen d'une technique de reprise dite de BRS à base de gravure RIBE, couramment utilisée pour les composants d'émission laser émettant par la tranche. Pour obtenir la localisation du courant au centre du milieu actif, les trois premiers modes de réalisation font intervenir une technique d'implantation ionique, et les trois derniers modes font intervenir une technique d'oxydation sélective. On va décrire chaque composant et le procédé de réalisation de celui-ci. Pour plus de clarté, on décrit la fabrication d'un composant mais les composants seront de préférence fabriqués en une plaque constituant une matrice de composants. D'un mode de réalisation à l'autre, les mêmes références désignent des couches ou des éléments analogues.

### Premier mode de réalisation

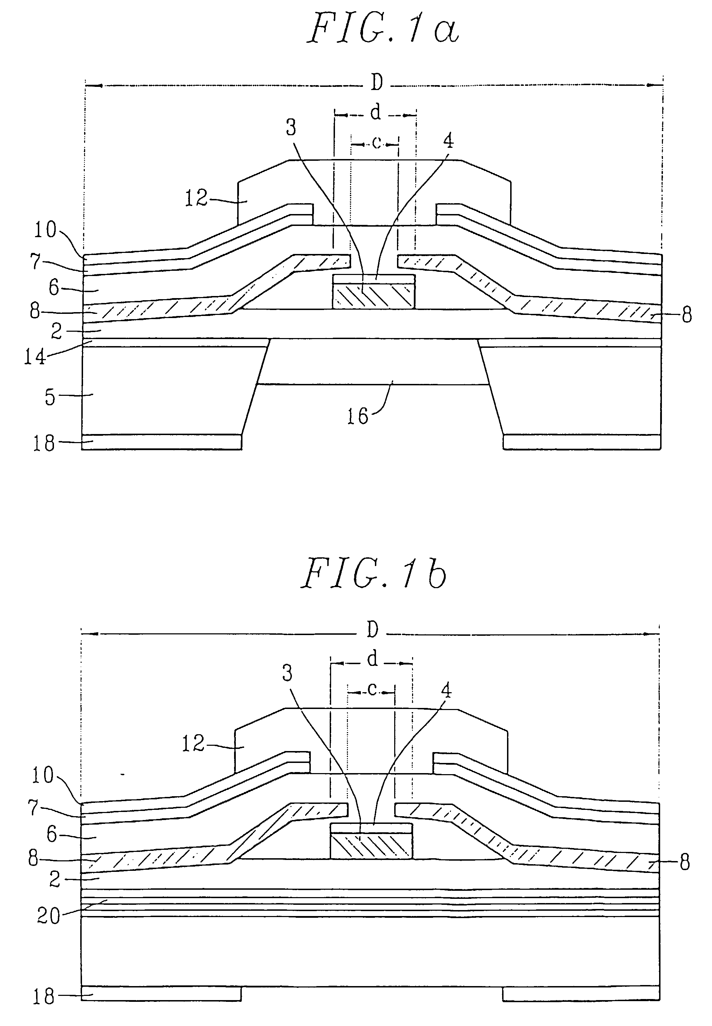

En référence à la figure 1, le composant selon le premier mode de réalisation est fabriqué au moyen d'un procédé présentant les étapes suivantes.

a) On réalise tout d'abord un empilement des trois couches 2, 3 et 4 du composant par épitaxie sur un substrat 5 en InP de type n.

En variante, ces trois couches peuvent être épitaxiées sur un réflecteur de Bragg composé d'un empilement de couches InP/InGaAsP, ou de AlAssb/AlGaAssb :
voir D. Blum, J.I. Fritz, R.L. Dawson, J.I. Hocard, F.J. Klen and J.T. Drummond : "MBc grown AlAsSb/GaAsSb distributed Bragg reflectors lattice matched to InP operating near 1.55 micron", J. Vac Sci Technol, B12(2), p 1122, 1994
   ou encore de AlPsb/GaPsb :
voir T. Anan, H. Shimomura and S. Sugou : "Improved reflectivity of AlPSb/GaPSb Bragg reflector for 1.55 micron wavelength", Electron. Lett., 8th Dec. 1994, vol 30, p 2138,
   les couches du réflecteur étant épitaxiées sur un substrat en InP.

Il est également possible de coller les couches 2, 3 et 4 sur un réflecteur de Bragg formé d'un empilement de couches AlAs/GaAs épitaxiées sur un substrat en GaAs :
voir C.L. Chua, C.H. Lin, Z.H. Zhu, YJL Lo, M. Hong, J.P. Mannaerts and R. Bhat : "Dielectrically bonded long wavelength vertical cavity laser on Ga As substrate using strain compensated Multiple quantum wells", IEEE Photon. Tech. Lett., vol 6, p 1400, Dec 1994.

Les trois couches 2, 3 et 4 se composent successivement d'une couche 2 en InP de type n, d'une couche de matériau actif 3 et d'une couche 4 en InP de type p de faible épaisseur protégeant la couche active lors des étapes d'épitaxie ou de reprise ultérieures. La couche 3 de matériau actif peut être formée soit de GaInAsP massif comme c'est le cas en l'espèce, soit d'une succession de puits quantiques contraints compensés InGaAs/InGaASP :
voir C.L. Chua, C.H. Lin, Z.H. Zhu, YJL Lo, M. Hong, J.P. Mannaerts and R. Bhat : "Dielectrically bonded long wavelength vertical cavity laser on Ga As substrate using strain compensated Multiple quantum wells", IEEE Photon. Tech. Lett., vol 6, p 1400, Dec 1994.

b) L'étape suivante consiste à graver la couche de matériau actif 3 et la couche 4 en InP dopé p par Usinage Ionique Réactif (RIBE) de manière à former un plot circulaire selon le procédé décrit dans le brevet FR 91 0272 de N. BOUADMA. Le plot présente une largeur, en l'espèce un diamètre d inférieur à la largeur, en l'espèce au diamètre D du composant achevé, c'est-à-dire au diamètre de l'empilement des couches ou des portions de couches définissant en propre le composant, le diamètre D du composant pouvant être fictif (composants en matrice) ou réel (composant distinct). On réalise ainsi dans la couche de matériau actif une zone d'injection de diamètre d limité par rapport au diamètre D du composant.

c) On épitaxie ensuite une couche 6 de phosphure d'indium dopé p à 1 ou 2 . 10¹⁸ cm⁻³ recouvrant le plot et la couche 2, lors d'un second cycle d'épitaxie appelé "reprise d'épitaxie". Cette couche 6 permet de confiner latéralement les porteurs injectés dans le plot actif. Puis on épitaxie sur la couche 6 une couche mince 7 d'InGaAs fortement dopée en trous (3 . 10¹⁹ cm⁻³) destinée à faciliter la prise de contact du côté p du composant.

d) On procède alors à l'étape d'implantation suivante :

On dépose une résine photosensible sur toute la surface du composant. On dispose un masque circulaire en regard du plot, le masque étant coaxial au plot et ayant une largeur, en l'espèce un diamètre inférieur au diamètre d du plot. On bombarde l'échantillon avec des ions H⁺ à une énergie suffisamment importante pour venir créer dans la couche 6 d'InP dopé p une région isolante 8. L'énergie et la dose d'ions implantés doivent être ajustées pour former en profondeur la région isolante 8 dans la couche d'InP qui permettra d'injecter le courant au centre du plot.

Cette région isolante 8 est continue dans la couche 6, sauf en son centre en regard du plot et du masque où la couche 6 demeure conductrice. Cette région isolante 8 a donc la forme d'une barrière circulaire et en coupe la forme de barrières latérales. La région isolante s'étend en regard du matériau actif en s'opposant au passage du courant. Au centre du composant, elle délimite en regard de la zone d'injection un canal circulaire pour le passage du courant. De même que le masque utilisé, ce canal a une largeur, en l'espèce un diamètre c inférieur au diamètre d de la zone d'injection. A la fin de l'étape d'implantation, on ôte le masque.

e) On dépose ensuite sur la couche 7 une couche métallique 10 par exemple en Pt et Au/Ti assurant la prise de contact p au sommet du composant. Puis, on réalise par gravure ionique ou chimique dans les couches 7 et 10 une ouverture circulaire coaxiale au plot actif et de diamètre supérieur ou égal à celui-ci.

On procède alors au dépôt d'un réflecteur de Bragg 12 au sommet du composant sur l'ouverture, ce réflecteur étant formé d'alternance SiO₂/Si, SiN/Si ou MgO/Si.

Si l'épitaxie de départ a été effectuée sur un substrat en InP dopé n comme c'est le cas pour le composant de la figure 1, on réalise ensuite le miroir du bas du composant. Pour cela, on grave chimiquement et sélectivement le substrat 5 en InP jusqu'à quelques microns de la zone active. Il aura fallu prévoir à cet effet sur le substrat 5 une couche d'arrêt 14 en GaInAs que l'on grave sélectivement ensuite. On définit ainsi dans le substrat une cavité ayant un fond s'étendant en regard du matériau actif, au voisinage de celui-ci. Dans cette cavité, on dépose un miroir diélectrique 16 (on peut utiliser les mêmes diélectriques que pour le miroir 12 du haut). On dépose enfin une couche métallique 18 de contact n à la base du composant.

On obtient ainsi un composant comportant sur un substrat 5 un empilement des couches successives suivantes :
- une couche 2 d'InP dopé n ;
- une couche 3 de matériau actif ;
- une couche 4 d'InP dopé p, ces deux dernières couches formant un plot sur la couche d'InP dopé n ;
- une couche 6 d'InP dopé p recouvrant le plot et la couche d'InP dopé n et comprenant la barrière circulaire ;
- une couche 7 de GaInAs dopé p ; et
- un contact métallique 10, ces deux dernière couches présentant en regard du plot une ouverture circulaire sur laquelle est disposé un miroir, le composant présentant un autre contact métallique 18 sur sa face inférieure.

La figure 1b présente une variante du composant selon ce mode de réalisation, dans laquelle l'épitaxie de départ a été effectuée non pas sur un substrat en InP mais sur un miroir de Bragg semiconducteur 20. Dans ce cas, il est inutile de réaliser la gravure de la cavité. On dépose la couche métallique 18 de contact n à la base du composant sur la face inférieure du miroir. Les autres parties du composant sont identiques.

On obtient ainsi un composant comportant sur un miroir un empilement semblable à celui précité.

### Deuxième mode de réalisation

Le composant selon le deuxième mode de réalisation est fabriqué suivant un procédé proche du premier mode à partir d'un substrat ou d'un des réflecteurs de Bragg décrits au a) du premier mode de réalisation.

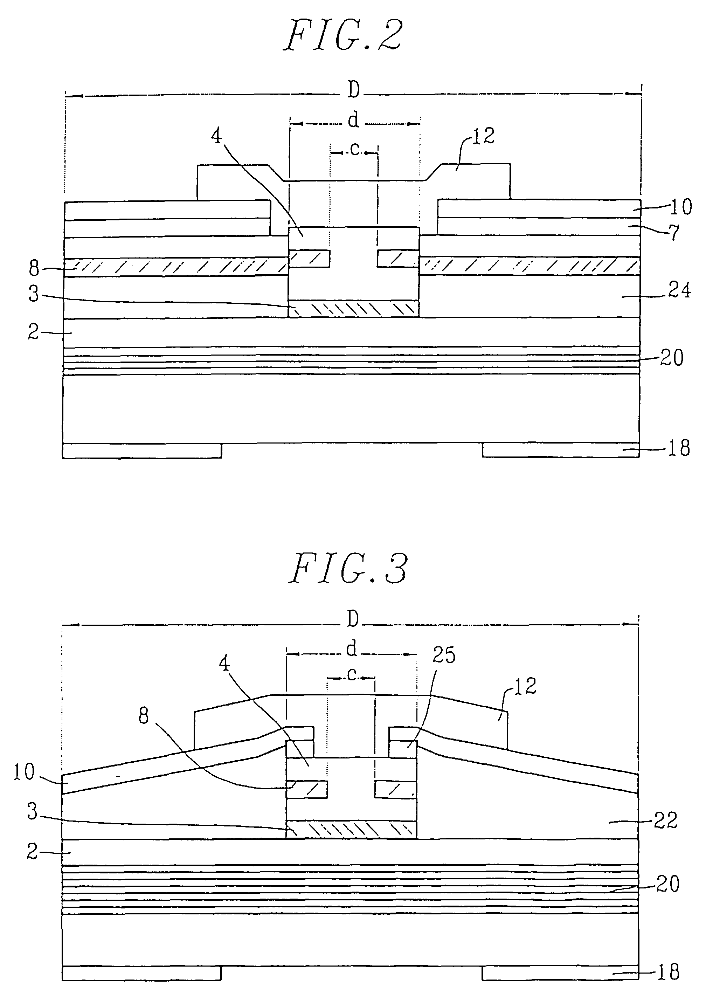

En l'espèce, le composant de la figure 2 est réalisé à partir d'un miroir semiconducteur 20.

Sur le substrat ou le réflecteur, on épitaxie cette fois quatre couches, à savoir successivement une couche 2 d'InP dopé n, une couche 3 de GaInAsP, une couche 4 d'InP dopé p et enfin une couche de GaInAs (non représentée).

On grave ensuite un plot circulaire comme au b) précité de sorte qu'on donne à la zone d'injection un diamètre d inférieur au diamètre D du composant.

Puis on dispose sur le plot un masque de reprise recouvrant le sommet du plot et on effectue autour du plot une épitaxie localisée d'une couche 24 d'InP dopé p sur la couche 2 d'InP dopé n, suivie d'une couche 7 d'InGaAs dopé p+.

On connaît des techniques de croissance par jets moléculaires chimiques (EJC) :
voir F. Alexandre, D. Zerguine, P. Launoy, J.L. Benchimol and J. Etrillard : "CBE selective embedded growth for quasi-planar GaAsIIBT application", J. Cryst. Growth, 127 (1993), p 221
   ou par épitaxies aux hydrures
voir O. Kjebon, S. Lourdudoss end J. Wallin : "Regrowth of semi insulating iron doped InP around reactive ion etched lasers mesas in <110> and <-110> directions by hybride vapour phase epitaxy", IPRM, 1994.

Ces techniques ont déjà permis de réaliser des croissances de plusieurs microns d'épaisseur localisées grâce à un masque approprié. Elles paraissent donc tout à fait adaptées pour enterrer le plot circulaire.

On ôte ensuite le masque de reprise et la couche de GaInAs recouvrant le plot.

On procède alors à l'étape d'implantation comme au d) du premier mode de réalisation. On réalise ainsi dans les couches 4 et 24 d'InP dopé p une barrière circulaire 8 s'opposant au passage du courant et délimitant en son centre un canal circulaire de passage du courant. Ce canal a un diamètre c inférieur au diamètre d du plot.

Puis, de même qu'au e), on dépose ensuite la couche métallique supérieure 10, on réalise l'ouverture supérieure, on dépose le miroir diélectrique supérieur 12 et on dépose la couche métallique inférieure 18, avec éventuellement gravure et dépôt d'un miroir inférieur diélectrique (comme sur la figure 1a).

On réalise ainsi un composant comportant sur un miroir 20 un empilement des couches successives suivantes :
- une couche 2 d'InP dopé n ;
- une couche 3 de matériau actif ;
- une couche 4 d'InP dopé p, ces deux dernières couches formant un plot sur la couche d'InP dopé n ;
- une couche 24 d'InP dopé p ;
- une couche 7 de GaInAs dopée p+, ces deux dernières couches s'étendant autour du plot sur la couche d'InP dopé n ; et
- un contact métallique 18,
la couche de GaInAs et le contact métallique présentant en regard du plot une ouverture circulaire de diamètre supérieur à celui du plot, sur laquelle est disposé un miroir, le composant présentant un autre contact métallique 18 sur sa face inférieure, la barrière circulaire 8 s'étendant dans les couches d'InP dopé p.

### Troisième mode de réalisation

Le composant selon le troisième mode de réalisation, représenté à la figure 3, est fabriqué selon un procédé proche du deuxième mode de réalisation.

Le procédé se déroule de façon identique jusqu'à l'étape de gravure du plot y compris. La couche de GaInAs au sommet du plot est visible cette fois sur la figure 3 et porte la référence 25.

Après gravure du plot, on dépose cette fois sur le composant une couche de polyimide 22 recouvrant le plot et la couche 2 d'InP dopé n. Puis, on effectue une gravure réactive de cette couche 22 afin de découvrir la surface de la couche 24 de GaInAs au sommet du plot.

On procède alors à l'étape d'implantation de la même façon qu'au d) du premier mode. On réalise ainsi dans la couche 4 du plot une barrière circulaire isolante délimitant en son centre un canal circulaire de passage du courant. Ce canal a un diamètre c inférieur au diamètre d du plot et de la zone active.

Puis, de même qu'au e) du premier mode de réalisation, on dépose la couche métallique supérieure 10, on réalise l'ouverture circulaire supérieure dans les couches 10 et 24, on dépose le miroir diélectrique supérieur 12, puis la couche métallique inférieure 18, avec éventuellement gravure et dépôt d'un miroir inférieur diélectrique. Toutefois, dans ce troisième mode de réalisation, l'ouverture gravée dans les couches 10 et 24 présente un diamètre inférieur au diamètre d du plot.

Il en résulte un composant comportant sur un miroir un empilement des couches successives suivantes :
- une couche 2 d'InP dopé n ;
- une couche 3 de matériau actif ;
- une couche 4 d'InP dopé p dans laquelle s'étend la barrière circulaire ;
- une couche 25 de GaInAs, ces trois dernières couches formant un plot sur la couche d'InP dopé n ;
- une couche 22 de polyimide s'étendant sur la couche d'InP dopé n autour du plot ; et
- un contact métallique 10 s'étendant sur le plot et la couche de polyimide,
la couche de GaInAs et le contact métallique présentant en regard du plot une ouverture circulaire de diamètre inférieur à celui du plot, sur laquelle est disposé un miroir 12, le composant présentant un autre contact métallique 18 sur sa face inférieure.

### Quatrième mode de réalisation

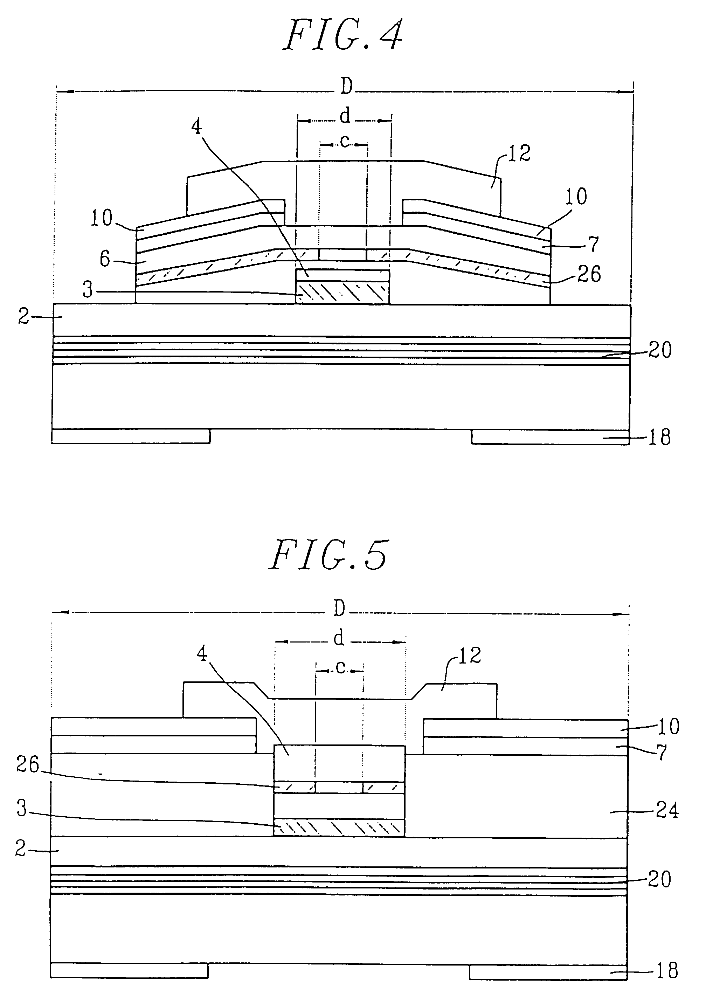

Le composant selon le quatrième mode de réalisation est représenté à la figure 4.

Le début du procédé de fabrication de ce composant est le même que dans le premier mode et reprend les étapes a) et b) de celui-ci, c'est-à-dire jusqu'à l'étape de gravure du plot y compris.

Puis lors d'un second cycle d'épitaxie, on réalise une couche 6 d'InP dopé p à 1 ou 2.10¹⁸ cm⁻³ recouvrant le plot et la couche 2 d'InP dopé n, en intercalant une couche 26 supplémentaire d'InAlAs dans la couche d'InP dopé p. On procède pour cela par épitaxies successives d'une première sous-couche d'InP, de la couche d'InAlAs, puis d'une deuxième sous-couche d'InP dopé p. Puis on épitaxie sur le tout la couche mince 7 d'InGaAs comme au c).

On procède ensuite à la gravure périphérique des couches 7, 6 et 26 de GaInAs, d'InP dopé p et d'InAlAs à distance du plot, jusqu'à la couche en InP dopé n.

On effectue alors l'oxydation sélective de la couche 26 d'InAlAs par attaque chimique humide à partir du bord de cette couche rendue accessible par la gravure. La technique d'oxydation sélective est connue et a déjà été utilisée pour réaliser des composants lasers à longueur d'onde λ = 1,55 µm à émission par la tranche à géométrie ruban dits à guidage par le gain,

voir J.M. Dallesasse, N. Holonyak, A.R. Sugg, T.A. Richard and N. El Zein, Appl. Phys. Lett, 57 (1990), p 2844.

Cette oxydation sélective réalise la barrière circulaire dans la couche 26 en InAlAs et définit en son centre le canal de passage du courant en regard de la zone active. On réalise la barrière de sorte que le diamètre c du canal est inférieur au diamètre d du plot.

Les étapes suivantes du procédé sont identiques à celles décrites au e) du premier mode.

On obtient donc un composant comportant sur un miroir 20 un empilement des couches successives suivantes :
- une couche 2 d'InP dopé n ;
- une couche 3 de matériau actif ;
- une couche 4 d'InP dopé p, ces deux dernières couches formant un plot sur la couche d'InP dopé n ;
- une couche 6 d'InP dopé p recouvrant le plot et la couche d'InP dopé n, dans laquelle est intercalée une couche 26 d'InAlAs comprenant la barrière circulaire ;
- une couche 7 de GaInAs dopé p ; et
- un contact métallique 10,
ces deux dernières couches présentant en regard du plot une ouverture circulaire sur laquelle est disposé un miroir 12, le composant présentant un autre contact métallique 18 sur sa face inférieure.

### Cinquième mode de réalisation

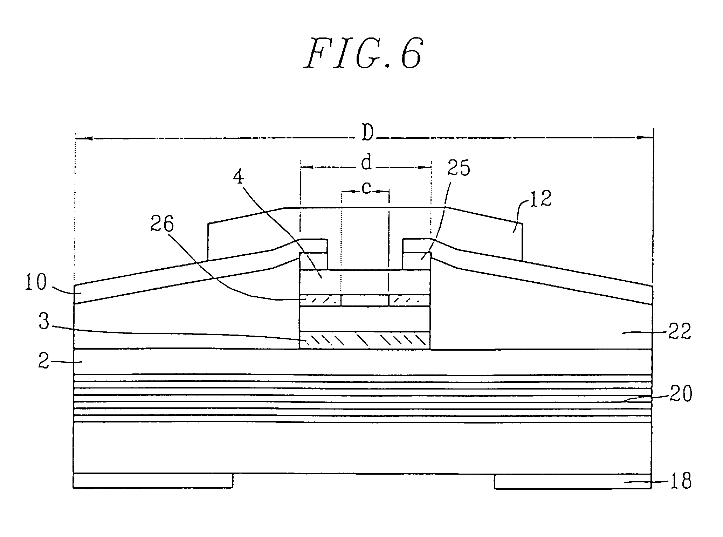

Le composant selon le cinquième mode de réalisation est représenté à la figure 5.

Comme dans le a) du premier mode, on effectue la première épitaxie sur un substrat ou un réflecteur 20 comme c'est le cas en l'espèce. Lors de cette épitaxie, on dépose successivement la couche 2 d'InP dopé n, la couche 3 de GaInAsP, la couche 4 d'InP dopé p en intercalant dans celle-ci une couche 26 d'InAlAs (c'est-à-dire comme plus haut en déposant une première sous-couche d'InP dopé p, la couche d'InAlAs puis une deuxième sous-couche d'InP dopé p) et enfin une couche de GaInAs non représentée.

On grave ensuite les couches de GaInAs, d'InP dopé p, d'InAlAs et de GaInAsP jusqu'à la couche 2 en InP dopé n pour former un plot circulaire comme au b).

On procède alors à l'oxydation sélective de la couche 26 d'InAlAs comme expliqué dans le quatrième mode. On forme ainsi dans le plot la barrière circulaire délimitant en son centre en regard de la zone d'injection un canal de passage du courant vérifiant la même condition dimensionnelle que plus haut.

On dépose ensuite sur le plot un masque de reprise recouvrant le sommet du plot et on effectue autour du plot une épitaxie localisée d'une couche 24 d'InP dopé p sur la couche 2 d'InP dopé n, suivie d'une couche 7 d'InGaAs dopé p+ autour du plot. On ôte ensuite le masque de reprise et la couche de GaInAs au sommet du plot.

La suite du procédé est identique aux étapes décrites au e) du premier mode.

On obtient donc un composant comportant sur un miroir 20 un empilement des couches successives suivantes :
- une couche 2 d'InP dopé n ;
- une couche 3 de matériau actif ;
- une couche 4 d'InP dopé p dans laquelle est intercalée une couche 26 d'InAlAs comprenant la barrière circulaire, les couches d'InP dopé p, d'InAlAs et de matériau actif formant un plot sur la couche d'InP dopé n ;
- une couche 24 d'InP dopé p ;
- une couche 7 de GaInAs dopée p+, ces deux dernières couches s'étendant autour du plot sur la couche d'InP dopé n ; et
- un contact métallique 10, la couche de GaInAs et le contact métallique présentant en regard du plot une ouverture circulaire de diamètre supérieur à celui du plot, sur laquelle est disposé un miroir, le composant présentant un autre contact métallique 18 sur sa face inférieure.

### Sixième mode de réalisation

La figure 6 présente un composant selon un sixième mode de réalisation de l'invention, fabriqué selon un procédé proche de celui du cinquième mode.

Le procédé est identique au précédent jusqu'à l'étape d'oxydation latérale sélective de la couche 26 d'InAlAs, y compris cette étape. La couche 25 de GaInAs du plot est visible sur la figure 6.

L'étape de reprise d'épitaxie localisée d'InP dopé p est remplacée ici par dépôt d'une couche 22 de polyimide recouvrant le plot et la couche 2 en InP dopé n comme dans le troisième mode de réalisation. On effectue ensuite la gravure réactive de cette couche 22 pour découvrir la couche 24 de GaInAs du plot.

La suite du procédé se déroule de la même façon que pour la fin du troisième mode de réalisation (dépôt d'un contact métallique, réalisation d'une ouverture de diamètre inférieur à celui du plot,...) et la zone d'injection et le canal vérifient les mêmes conditions dimensionnelles que dans le troisième mode.

Il en résulte donc un composant comportant sur un miroir 20 un empilement des couches successives suivantes :
- une couche 2 d'InP dopé n ;
- une couche 3 de matériau actif ;
- une couche 4 d'InP dopé p dans laquelle est intercalée une couche d'InAlAs comprenant la barrière circulaire 26 ;
- une couche 25 de GaInAs, les couches de matériau actif, d'InP dopé p, d'InAlAs et de GaInAs formant un plot sur la couche d'InP dopé n ;
- une couche 22 de polyimide s'étendant sur la couche d'InP dopé n autour du plot ; et
- un contact métallique 10 s'étendant sur le plot et la couche de polyimide,
la couche de GaInAs et le contact métallique présentant en regard du plot une ouverture circulaire de diamètre inférieur à celui du plot, sur laquelle est disposé un miroir, le composant présentant un autre contact métallique 18 sur sa face inférieure.

Dans chacun de ces composants, le milieu amplificateur comporte ainsi une barrière circulaire 8 ou 26 s'étendant en regard du matériau actif et s'opposant au passage du courant. Cette barrière délimite en son centre en regard de la zone d'injection un canal de passage du courant ayant un diamètre c inférieur au diamètre d de la zone d'injection. De plus, le diamètre d de la zone d'injection est dans chaque cas inférieur au diamètre D du composant.

Dans chacun de ces composants, on obtient un confinement efficace de l'injection et une bonne répartition des porteurs injectés, la densité de porteurs dans la zone d'injection étant plus forte au centre que sur les côtés. Le gain modal est élevé et le courant de seuil est réduit en rendant possible d'émettre à température ambiante inférieure à 30°C à une longueur d'onde λ comprise entre 1,3 et 1,55 µm, y compris ces valeurs.

## Revendications

1. Composant d'émission laser à cavité verticale émettant par la surface à une longueur d'onde comprise entre 1,3 et 1,55 µm, comportant une couche (3) de matériau actif présentant une zone d'injection de largeur (d) inférieure à la largeur du composant, cette zone émettant un rayonnement lors de l'injection d'un courant électrique, le composant comportant en outre un milieu amplificateur du rayonnement et deux miroirs (12, 16 ; 12, 20) réfléchissant à la longueur d'onde d'émission et disposés respectivement au-dessus et au-dessous du milieu amplificateur, caractérisé en ce que le milieu amplificateur comporte une barrière circulaire (8 ; 26) s'étendant en regard du matériau actif (3), cette barrière s'opposant au passage du courant et délimitant en son centre en regard de la zone d'injection un canal de passage du courant, ce canal ayant une largeur (c) inférieure à la largeur (d) de la zone d'injection.

2. Composant selon la revendication 1, caractérisé en ce qu'il comporte sur un substrat (5) ou sur un miroir (20) un empilement des couches successives suivantes :
- une couche (2) d'InP dopé n ;
- une couche (3) de matériau actif ;
- une couche (4) d'InP dopé p, ces deux dernières couches formant un plot sur la couche d'InP dopé n ;
- une couche (6) d'InP dopé p recouvrant le plot et la couche d'InP dopé n et comprenant la barrière circulaire (8) ;
- une couche (7) de GaInAs dopé p ; et
- un contact métallique (10), ces deux dernières couches présentant en regard du plot une ouverture circulaire sur laquelle est disposé un miroir (12), le composant présentant un autre contact métallique (18) sur sa face inférieure.

3. Composant selon la revendication 1, caractérisé en ce qu'il comporte sur un substrat ou sur un miroir (20) un empilement des couches successives suivantes :
- une couche (2) d'InP dopé n ;
- une couche (3) de matériau actif ;
- une couche (4) d'InP dopé p, ces deux dernières couches formant un plot sur la couche d'InP dopé n ;
- une couche (24) d'InP dopé p ;
- une couche (7) de GaInAs dopée p+, ces deux dernières couches s'étendant autour du plot sur la couche d'InP dopé n ; et
- un contact métallique (10),
la couche de GaInAs et le contact métallique présentant en regard du plot une ouverture circulaire sur laquelle est disposé un miroir (12), le composant présentant un autre contact métallique (18) sur sa face inférieure, la barrière circulaire (8) s'étendant dans les couches d'InP dopé p.

4. Composant selon la revendication 1, caractérisé en ce qu'il comporte sur un substrat ou sur un miroir (20) un empilement des couches successives suivantes :
- une couche (2) d'InP dopé n ;
- une couche (3) de matériau actif ;
- une couche (4) d'InP dopé p dans laquelle s'étend la barrière circulaire (8) ;
- une couche (24) de GaInAs, ces trois dernières couches formant un plot sur la couche d'InP dopé n ;
- une couche (22) de polyimide s'étendant sur la couche d'InP dopé n autour du plot ; et
- un contact métallique (10) s'étendant sur le plot et la couche de polyimide,
la couche de GaInAs et le contact métallique présentant en regard du plot une ouverture circulaire de largeur inférieure à celle du plot, sur laquelle est disposé un miroir (12), le composant présentant un autre contact métallique (18) sur sa face inférieure.

5. Composant selon la revendication 1, caractérisé en ce qu'il comporte sur un substrat ou sur un miroir un empilement des couches successives suivantes :
- une couche (2) d'InP dopé n ;
- une couche (3) de matériau actif ;
- une couche (4) d'InP dopé p, ces deux dernières couches formant un plot sur la couche d'InP dopé n ;
- une couche (6) d'InP dopé p recouvrant le plot et la couche d'InP dopé n, dans laquelle est intercalée une couche (26) d'InAlAs comprenant la barrière circulaire ;
- une couche (7) de GaInAs dopé p ; et
- un contact métallique (10),
ces deux dernières couches présentant en regard du plot une ouverture circulaire sur laquelle est disposé un miroir, le composant présentant un autre contact métallique (18) sur sa face inférieure.

6. Composant selon la revendication 1, caractérisé en ce qu'il comporte sur un substrat ou un miroir un empilement des couches successives suivantes :
- une couche (2) d'InP dopé n ;
- une couche (3) de matériau actif ;
- une couche (4) d'InP dopé p dans laquelle est intercalée une couche (26) d'InAlAs comprenant la barrière circulaire, les couches d'InP dopé p, d'InAlAs et de matériau actif formant un plot sur la couche d'InP dopé n ;
- une couche (24) d'InP dopé p ;
- une couche (7) de GaInAs dopée p+, ces deux dernières couches s'étendant autour du plot sur la couche d'InP dopé n ; et
- un contact métallique (10),
la couche de GaInAs et le contact métallique présentant en regard du plot une ouverture circulaire sur laquelle est disposé un miroir (12), le composant présentant un autre contact métallique (18) sur sa face inférieure.

7. Composant selon la revendication 1, caractérisé en ce qu'il comporte sur un substrat ou un miroir (20) un empilement des couches successives suivantes :
- une couche (2) d'InP dopé n ;
- une couche (3) de matériau actif ;
- une couche (4) d'InP dopé p dans laquelle est intercalée une couche (26) d'InAlAs comprenant la barrière circulaire ;
- une couche (24) de GaInAs, les couches de matériau actif, d'InP dopé p, d'InAlAs et de GaInAs formant un plot sur la couche d'InP dopé n ;
- une couche (22) de polyimide s'étendant sur la couche d'InP dopé n autour du plot ; et
- un contact métallique (10) s'étendant sur le plot et la couche de polyimide,
la couche de GaInAs et le contact métallique présentant en regard du plot une ouverture circulaire de largeur inférieure à celle du plot, sur laquelle est disposé un miroir, le composant présentant un autre contact métallique (18) sur sa face inférieure.

8. Composant selon l'une des revendications 1 à 7, caractérisé en ce que l'empilement est disposé sur un substrat (5) en InP dopé n, un contact métallique (18) s'étendant sur la face inférieure de ce substrat, le substrat présentant une cavité ayant un fond s'étendant en regard du matériau actif (3) au voisinage de celui-ci, un miroir (16) étant disposé dans cette cavité.

9. Composant selon l'une des revendications 1 à 7, caractérisé en ce que l'empilement est disposé sur un miroir semiconducteur (20), un contact métallique (18) s'étendant sur la face inférieure de ce miroir.

10. Procédé de fabrication d'un composant selon la revendication 2, caractérisé en ce qu'il comprend les étapes consistant à :
- réaliser sur un substrat (5) ou sur un miroir (20) un empilement comportant successivement une couche (2) d'InP dopé n, une couche (3) de matériau actif et une couche (4) d'InP dopé p ;
- graver les deux dernières couches pour former un plot sur la couche d'InP dopé n ;
- épitaxier sur le plot et la couche d'InP dopé n une couche (6) d'InP dopé p puis une couche (7) de GaInAs dopé p ;
- déposer sur cette dernière une résine photosensible ;
- disposer en regard du sommet du plot un masque de largeur inférieure à la largeur du plot ;
- bombarder le composant avec des ions H⁺ de façon à réaliser la barrière circulaire (8) dans la couche d'InP dopé p recouvrant le plot ;
- ôter le masque ;
- déposer une couche métallique (10) sur le composant ;
- graver dans la couche métallique et la couche de GaInAs une ouverture circulaire s'étendant en regard du plot et déposer un miroir (12) sur cette ouverture ; et
- déposer une couche métallique (18) sur la face inférieure du composant.

11. Procédé de fabrication d'un composant selon la revendication 3, caractérisé en ce qu'il comprend les étapes consistant à :
- réaliser sur un substrat ou sur un miroir (20) un empilement comportant successivement une couche (2) d'InP dopé n, une couche (3) de matériau actif, une couche (4) d'InP dopé p et une couche de GaInAs ;
- graver les trois dernières couches pour former un plot sur la couche d'InP dopé n ;
- déposer un masque de reprise recouvrant le sommet du plot ;
- effectuer une épitaxie localisée autour du plot d'une couche (24) d'InP dopé p, puis d'une couche (7) de GaInAs dopé p+ ;
- ôter le masque ;
- déposer sur le composant une résine photosensible ;
- disposer en regard du sommet du plot un masque de largeur inférieure à la largeur du plot ;
- bombarder le composant avec des ions H⁺ de façon à réaliser la barrière circulaire dans les couches d'InP dopé p ;
- ôter le masque ;
- déposer une couche métallique (10) sur le composant ;
- graver dans la couche métallique et la couche de GaInAs une ouverture circulaire s'étendant en regard du plot et déposer un miroir (12) sur cette ouverture ; et
- déposer une couche métallique (18) sur la face inférieure du composant.

12. Procédé de fabrication d'un composant selon la revendication 4, caractérisé en ce qu'il comprend les étapes consistant à :
- réaliser sur un substrat ou sur un miroir (20) un empilement comportant successivement une couche (2) d'InP dopé n, une couche (3) de matériau actif, une couche (4) d'InP dopé p et une couche (25) de GaInAs ;
- graver les trois dernières couches pour former un plot sur la couche d'InP dopé n ;
- déposer une couche (22) de polyimide recouvrant le plot et la couche d'InP dopé n ;
- effectuer une gravure réactive de la couche de polyimide pour découvrir le sommet du plot ;
- déposer sur le composant une résine photosensible ;
- disposer en regard du sommet du plot un masque de largeur inférieure à la largeur de celui-ci ;
- bombarder le composant avec des ions H⁺ de façon à réaliser la barrière circulaire (8) dans la couche d'InP dopé p ;
- ôter le masque ;
- déposer une couche métallique (10) sur le composant ;
- graver dans la couche de GaInAs et la couche métallique une ouverture circulaire s'étendant en regard du plot et de largeur inférieure à la largeur du plot, et déposer un miroir (12) sur cette ouverture ; et
- déposer une couche métallique (18) sur la face inférieure du composant.

13. Procédé de fabrication d'un composant selon la revendication 5, caractérisé en ce qu'il comprend les étapes consistant à :
- réaliser sur un substrat ou sur un miroir (20) un empilement comportant successivement une couche (2) d'InP dopé n, une couche (3) de matériau actif et une couche (4) d'InP dopé p ;
- graver les deux dernières couches pour former un plot sur la couche d'InP dopé n ;
- épitaxier sur le plot et la couche d'InP dopé n une couche (6) d'InP dopé p en intercalant dans celle-ci une couche (26) d'InAlAs, puis épitaxier une couche (7) de GaInAs dopé p ;
- graver ces trois dernières couches à distance du plot jusqu'à la couche d'InP dopé n ;
- effectuer une oxydation latérale sélective par attaque chimique humide de la couche d'InAlAs de façon à réaliser dans celle-ci la barrière circulaire ;
- déposer une couche métallique (10) sur le composant ;
- graver dans la couche métallique et la couche de GaInAs une ouverture circulaire s'étendant en regard du plot et déposer un miroir (12) sur cette ouverture ; et
- déposer une couche métallique (18) sur la face inférieure du composant.

14. Procédé de fabrication d'un composant selon la revendication 6, caractérisé en ce qu'il comprend les étapes consistant à :
- réaliser sur un substrat ou sur un miroir (20) un empilement comportant successivement une couche (2) d'InP dopé n, une couche (3) de matériau actif, une couche (4) d'InP dopé p en intercalant dans celle-ci une couche (26) d'InAlAs, et une couche de GaInAs ;
- graver les quatre dernières couches pour former un plot sur la couche d'InP dopé n ;
- effectuer une oxydation latérale sélective par attaque chimique humide de la couche d'InAlAs de façon à réaliser dans celle-ci la barrière circulaire ;
- déposer un masque de reprise recouvrant le sommet du plot ;
- effectuer une épitaxie localisée autour du plot d'une couche (24) d'InP semi-isolant puis d'une couche (7) de GaInAs dopé p+;
- ôter le masque et la couche de GaInAs du plot ;
- graver dans la couche métallique et la couche de GaInAs une ouverture circulaire s'étendant en regard du plot, et déposer un miroir (12) sur cette ouverture ; et
- déposer une couche métallique (18) sur la face inférieure du composant.

15. Procédé de fabrication d'un composant selon la revendication 7, caractérisé en ce qu'il comprend les étapes consistant à :
- réaliser sur un substrat ou sur un miroir (20) un empilement comportant successivement une couche (2) d'InP dopé n, une couche (3) de matériau actif, une couche (4) d'InP dopé p en intercalant dans celle-ci une couche (26) d'InAlAs, et une couche de GaInAs ;
- graver les quatre dernières couches pour former un plot sur la couche d'InP dopé n ;
- effectuer une oxydation latérale sélective par attaque chimique humide de la couche d'InAlAs de façon à réaliser dans celle-ci la barrière circulaire ;
- déposer une couche (22) de polyimide recouvrant le plot et la couche d'InP dopé n ;
- effectuer une gravure réactive de la couche de polyimide pour découvrir le sommet du plot ;
- déposer une couche métallique (10) sur le composant ;
- graver dans la couche de GaInAs et la couche métallique une ouverture circulaire s'étendant en regard du plot et de largeur inférieure à la largeur du plot, et déposer un miroir (12) sur cette ouverture ; et
- déposer une couche métallique (18) sur la face inférieure du composant.

## Patentansprüche

1. Bauteil für die Laseremission mit einem vertikalem Hohlraum, das über die Oberfläche bei einer Wellenlänge zwischen 1,3 und 1,55 µm emittiert und eine Schicht (3) aus einem aktiven Material mit einer Injektionszone einer Breite (d) aufweist, die kleiner als die Breite des Bauteils ist, wobei diese Zone bei der Injektion von elektrischem Strom eine Strahlung emittiert, und das Bauteil außerdem ein Medium für die Verstärkung der Strahlung und zwei Spiegel (12, 16; 12, 20) aufweist, die bei der Wellenlänge der Emission reflektieren und jeweils oberhalb und unterhalb des verstärkenden Mediums angeordnet sind,
**dadurch gekennzeichnet, dass**
das verstärkende Medium eine kreisförmige Barriere 8; 26) enthält, die gegenüber dem aktiven Material (3) verläuft, und diese Barriere der Passage des Stroms entgegenwirkt und in ihrem Zentrum gegenüber der Injektionszone einen Kanal für die Strompassage eingrenzt, wobei dieser Kanal eine Weite (c) hat, die unter der Breite (d) der Injektionszone liegt.

2. Bauteil nach Anspruch 1,
**dadurch gekennzeichnet, dass**
es auf einem Substrat (5) oder auf einem Spiegel (20) einen Stapel der folgenden Schichten enthält:
- eine n-dotierte InP-Schicht (2);
- eine Schicht (3) aus einem aktiven Material;
- eine p-dotierte InP-Schicht (4), wobei diese beiden letzteren Schichten eine Echoanzeige auf der n-dotierten InP-Schicht bilden;
- eine p-dotierte InP-Schicht (6), welche die Echoanzeige und die n-dotierte InP-Schicht überdeckt und die kreisförmige Barriere (8) enthält;
- eine p-dotierte GaInAs-Schicht (7); und
- einen metallischen Kontakt (10), wobei diese beiden letzteren Schichten gegenüber der Echoanzeige eine kreisförmige Öffnung aufweisen, auf die ein Spiegel (12) aufgesetzt ist, und dieses Bauteil an seiner Unterseite einen weiteren metallischen Kontakt (18) enthält.

3. Bauteil nach Anspruch 1,
**dadurch gekennzeichnet, dass**
es auf einem Substrat oder einem Spiegel (20) einen Stapel aus den folgenden Schichten enthält:
- eine n-dotierte InP-Schicht (2);
- eine Schicht (3) aus einem aktiven Material;
- eine p-dotierte InP-Schicht (4), wobei diese beiden letzteren Schichten auf der n-dotierten InP-Schicht eine Echoanzeige herstellen;
- eine p-dotierte InP-Schicht (24);
- eine p+-dotierte GaInAs-Schicht (7), wobei diese beiden letzteren Schichten rund um die Echoanzeige auf der n-dotierten InP-Schicht angeordnet sind; und
- einen metallischen Kontakt (10),
wobei die GaInAs-Schicht und der metallische Kontakt gegenüber der Echoanzeige eine kreisförmige Öffnung aufweisen, in die ein Spiegel (12) eingesetzt ist, und dieses Bauteil außerdem an seiner Unterseite einen weiteren metallischen Kontakt (18) aufweis, und die kreisförmige Barriere (8) in den p-dotierten InP-Schichten verläuft.

4. Bauteil nach Anspruch 1,
**dadurch gekennzeichnet, dass**
es auf einem Substrat oder einem (20) Spiegel einen Stapel aus den folgenden Schichten enthält:
- eine n-dotierte InP-Schicht (2);
- eine Schicht (3) aus einem aktiven Material;
- eine p-dotierte InP-Schicht (4), welche die kreisförmige Barriere (8) enthält;
- eine GaInAs-Schicht (24), wobei diese drei letzteren Schichten auf der n-dotierten InP-Schicht eine Echoanzeige bilden;
- eine Polyimidschicht (22), welche auf der n-dotierten InP-Schicht rund um die Echoanzeige angeordnet ist; und
- einen metallischen Kontakt (10), welcher auf der Echoanzeige und der Polyimidschicht angeordnet ist,
wobei die GaInAs-Schicht und der metallische Kontakt gegenüber der Echoanzeige eine kreisförmige Öffnung mit einem Durchmesser aufweisen, der kleiner als der Durchmesser der Echoanzeige ist, auf der ein Spiegel (12) angeordnet ist, und das Bauteil an seiner Unterseite einen weiteren metallischen Kontakt (18) aufweist.

5. Bauteil nach Anspruch 1,
**dadurch gekennzeichnet, dass**
es auf einem Substrat oder einem Spiegel einen Stapel aus den folgenden Schichten aufweist:
- eine n-dotierte InP-Schicht (2);
- eine Schicht (3) aus einem aktivem Material;
- eine p-dotierte InP-Schicht (4), wobei diese beiden letzteren Schichten eine Echoanzeige auf der n-dotierten InP-Schicht bilden;
- eine p-dotierte InP-Schicht (6), welche die Echoanzeige und die n-dotierte InP-Schicht überdeckt, in die eine InAlAs-Schicht (26) eingelegt ist, welche die kreisförmige Barriere enthält;
- eine p-dotierte GaInAs-Schicht (7); und
- einen metallischen Kontakt (10),
wobei diese beiden letzteren Schichten gegenüber der Echoanzeige eine kreisförmige Öffnung aufweisen, in die ein Spiegel eingesetzt ist, und das Bauteil an seiner Unterseite einen weiteren metallischen Kontakt (18) aufweist.

6. Bauteil nach Anspruch 1,
**dadurch gekennzeichnet, dass**
es auf einem Substrat oder einem Spiegel einen Stapel aus den folgenden Schichten aufweist:
- eine n-dotierte InP-Schicht (2);
- eine Schicht (3) aus einem aktivem Material;
- eine p-dotierte InP-Schicht (4), in die eine InAlAs-Schicht (26) zwischengelegt ist, welche die kreisförmige Barriere, die p-dotierte InP-Schicht, die InAlAs-Schicht und die Schicht aus einem aktivem Material enthält, welche eine Echoanzeige auf der n-dotierten InP-Schicht bilden;
- eine +p-dotierte InP-Schicht (24),
- eine p+-dotierte GaInAs-Schicht (7), wobei diese beiden letzteren Schichten rund um die Echoanzeige auf der n-dotierten InP-Schicht angeordnet sind; und
- einen metallischen Kontakt (10),
wobei die GaInAs-Schicht und der metallische Kontakt gegenüber der Echoanzeige eine kreisförmige Öffnung aufweisen, in die ein Spiegel (12) eingesetzt ist, wobei das Bauteil an seiner Unterseite einen weiteren metallischen Kontakt (18).

7. Bauteil nach Anspruch 1,
**dadurch gekennzeichnet, dass**
es auf einem Substrat oder einem Spiegel einen Stapel aus den folgenden Schichten aufweist:
- eine n-dotierte InP-Schicht (2);
- eine Schicht (3 aus einem aktivem Material;)
- eine p-dotierte InP-Schicht (4), in die eine InAlAs-Schicht (26) zwischengelegt ist, welche die kreisförmige Barriere enthält;
- eine GaInAs-Schicht (24), wobei die Schichten aus dem aktiven Material, der p-dotierten InP-Schicht, der InAlAs-Schicht und der GaInAs-Schicht auf der n-dotierten InP-Schicht eine Echoanzeige bilden;
- eine Polyimidschicht (22), welche auf der n-dotierten InP-Schicht rund um die Echoanzeige angeordnet ist, und
- einen metallischen Kontakt (10), welcher auf der Echoanzeige und der Polyimidschicht angeordnet ist,
wobei die GaInAs-Schicht und der metallische Kontakt gegenüber der Echoanzeige eine kreisförmige Öffnung mit einer Weite aufweisen, die kleiner ist, als die Breite der Echoanzeige, auf die ein Spiegel aufgesetzt ist, und das Bauteil an seiner Unterseite einen weiteren metallischen Kontakt (18) aufweist.

8. Bauteil nach einem der Ansprüche 1 bis 7,
**dadurch gekennzeichnet, dass**
der Stapel auf ein Substrat (5) aus n-dotiertem InP aufgelegt ist und an der Unterseite des Substrats ein metallischer Kontakt (18) angeordnet ist, und das Substrat einen Hohlraum mit einem Boden aufweist, der gegenüber dem aktiven Material (3) in dessen Nähe verläuft, und dass in diesen Hohlraum ein Spiegel (16) eingesetzt ist.

9. Bauteil nach einem der Ansprüche 1 bis 7,
**dadurch gekennzeichnet, dass**
der Stapel auf einen Halbleiterspiegel (20) aufgesetzt wird und an der Unterseite dieses Spiegels ein metallischer Kontakt (18) angeordnet ist.

10. Verfahren für die Herstellung eines Bauteils nach Anspruch 2,
**dadurch gekennzeichnet, dass**
es folgende Schritte umfasst:
- Herstellung auf einem Substrat (5) oder einem Spiegel (20) eines Stapels, welcher nacheinander eine n-dotierte InP-Schicht (2), eine Schicht (3) aus einem aktiven Material und eine p-dotierte Schicht (4) enthält;
- Ätzen dieser beiden Schichten, um auf der n-dotierten InP-Schicht eine Echoanzeige herzustellen;
- auf die Echoanzeige und die n-dotierte InP-Schicht eine p-dotierte InP-Schicht (6) und dann eine p-dotierte GaInAs-Schicht (7) epitaxiert wird;
- auf letztere Schicht ein lichtempfindliches Harz aufgetragen wird;
- auf den Scheitel der Echoanzeige eine Maske aufgelegt wird, deren Breite geringer ist, als die Breite der Echoanzeige;
- Bombardierung des Bauteils mit H+-Ionen, um die kreisförmige Barriere (8) in der p-dotierten InP-Schicht herzustellen, welche die Echoanzeige überdeckt;
- die Maske wird abgenommen;
- auf das Bauteil wird eine metallische Schicht (10) aufgetragen;
- in die metallische Schicht und die GaInAs-Schicht wird eine kreisförmige Öffnung geätzt, welche gegenüber der Echoanzeige verläuft und in die ein Spiegel (12) eingesetzt wird; und
- Auftrag einer metallischen Schicht (18) an der Unterseite des Bauteils.

11. Verfahren für die Herstellung eins Bauteils nach Anspruch 3,
**dadurch gekennzeichnet, dass**
- auf ein Substrat oder einen Spiegel (20) ein Stapel aufgebracht wird, der nacheinander eine n-dotierte InP-Schicht (2), eine Schicht (3) aus einem aktiven Material, eine p-dotierte InP-Schicht (4) und eine GaInAs-Schicht aufweist;
- diese drei letzteren Schichten geätzt werden, um auf der n-dotierten InP-Schicht eine Echoanzeige herzustellen;
- Auflegen einer Wiederholungsmaske, welche den Scheitel der Echoanzeige überdeckt;
- Durchführen einer lokalen Epitaxie rund um die Echoanzeige einer p-dotierten InP-Schicht (24) und dann einer p+-dotierten GaInAs-Schicht (7);
- die Maske wird abgenommen;
- auf das Bauteil wird ein lichtempfindliches Harz aufgetragen;
- auf den Scheitel der Echoanzeige wird eine Maske aufgelegt, deren Breite geringer ist, als die Breite der Echoanzeige;
- Bombardierung des Bauteils mit H+-Ionen, um in den p-dotierten InP-Schichten die kreisförmige Barriere herzustellen;
- die Maske wird abgenommen,
- Auftrag einer metallischen Schicht (10) auf das Bauteil;
- Ätzen einer kreisförmigen Öffnung in der metallischen Schicht und der GaInAs-Schicht, welche gegenüber der Echoanzeige liegt und Einsetzen eines Spiegels (12) in diese Öffnung; und
- Auftrag einer metallischen Schicht (18) an der Unterseite des Bauteils.

12. Verfahren für die Herstellung eines Bauteils nach Anspruch 4,
**dadurch gekennzeichnet, dass**
es die folgenden Schritte umfasst:
- Herstellung auf einem Substrat oder einem Spiegel (20) eines Stapels, welcher nacheinander eine n-dotierte InP-Schicht (2), eine Schicht (3) aus einem aktiven Material, eine p-dotierte InP-Schicht (4) und eine GaInAs-Schicht (25) enthält;
- Ätzung dieser drei Schichten, um auf der n-dotierten InP-Schicht eine Echoanzeige herzustellen;
- Auftrag einer Polyimidschicht (22), welche die Echoanzeige und die n-dotierte InP-Schicht überdeckt;
- Durchführung einer reaktiven Ätzung der Polyimidschicht, um den Scheitel der Echoanzeige freizulegen;
- Auftrag eines lichtempfindlichen Harzes auf das Bauteil;
- Auflegen auf den Scheitel der Echoanzeige einer Maske, deren Breite geringer ist, als die Breite der Echoanzeige;
- Bombardierung des Bauteils mit H+-Ionen, um die kreisförmige Barriere (8) in der p-dotierten InP-Schicht herzustellen;
- die Maske wird abgenommen;
- auf das Bauteil wird eine metallische Schicht (10) aufgetragen;
- in die GaInAs-Schicht und die metallische Schicht wird eine kreisförmige Öffnung geätzt, welche gegenüber der Echoanzeige liegt und eine Breite hat, die kleiner ist, als die Breite der Echoanzeige, und in diese Öffnung wird ein Spiegel (12) eingesetzt, und
- Auftrag einer metallischen Schicht (18) auf die Unterseite des Bauteils.

13. Verfahren für die Herstellung eines Bauteils nach Anspruch 5,
**dadurch gekennzeichnet, dass**
es die folgenden Schritte umfasst:
- Herstellung auf einem Substrat oder einem Spiegel (20) eines Stapels, welcher nacheinander eine n-dotierte InP-Schicht (2), eine Schicht (3) aus einem aktiven Material und eine p-dotierte InP-Schicht (4) enthält;
- Ätzen dieser beiden Schichten, um auf der n-dotierten InP-Schicht eine Echoanzeige herzustellen;
- Epitaxie auf der Echoanzeige und der n-dotierten InP-Schicht einer p-dotierten InP-Schicht (6) mit einer dazwischen angeordneten InAlAs-Schicht (26), und anschließende Epitaxie einer p-dotierten GaInAs-Schicht (7);
- Ätzung dieser drei Schichten im Abstand zu der Echoanzeige bis zu der n-dotierten InP-Schicht;
- Durchführung einer seitlichen selektiven Oxidation durch feuchten chemischen Angriff der InAlAs-Schicht, um dadurch in dieser Schicht die kreisförmige Barriere herzustellen;
- Auftrag einer metallischen Schicht (10) auf das Bauteil;
- Ätzen in der metallischen Schicht und der GaInAs-Schicht einer kreisförmigen Öffnung gegenüber der Echoanzeige und Einsetzen eines Spiegels (12) in diese Öffnung; und
- Auftrag einer metallischen Schicht (18) an der Unterseite des Bauteils.

14. Verfahren für die Herstellung eines Bauteils nach Anspruch 6,
**dadurch gekennzeichnet, dass**
es die folgenden Schritte umfasst:
- Herstellung auf einem Substrat oder einem Spiegel (20) eines Stapels, welcher nacheinander eine n-dotierte InP-Schicht (2), eine Schicht (3) aus einem aktiven Material und eine p-dotierte InP-Schicht (4) enthält, zwischen denen eine InAlAs-Schicht (26) und eine GaInAs-Schicht gelegt ist;
- Ätzen dieser vier Schichten, um auf der n-dotierten InP-Schicht eine Echoanzeige herzustellen;
- Durchführung einer selektiven seitlichen Oxidation durch einen feuchten chemischen Angriff der InAlAs-Schicht, um darin eine kreisförmige Barriere herzustellen;
- Auftrag einer Wiederholungsmaske, welche den Scheitel der Echoanzeige überdeckt;
- Durchführung einer lokalen Epitaxie rund um die Echoanzeige einer halbisolierenden InP-Schicht (24) und dann einer p+-dotierten GaInAs-Schicht (7);
- Abnahme der Maske und der GaInAs-Schicht von der Echoanzeige;
- Ätzung dieser drei Schichten im Abstand zu der Echoanzeige bis zu der n-dotierten InP-Schicht;
- Durchführung einer seitlichen selektiven Oxidation durch feuchten chemischen Angriff der InAlAs-Schicht, um dadurch in dieser Schicht die kreisförmige Barriere herzustellen;
- Auftrag einer metallischen Schicht (10) auf dem Bauteil;
- Ätzen in der metallischen Schicht und der GaInAs-Schicht einer kreisförmigen Öffnung gegenüber der Echoanzeige und Einsetzen eines Spiegels (12) in diese Öffnung; und
- Auftrag einer metallischen Schicht (18) an der Unterseite des Bauteils.

15. Verfahren für die Herstellung eines Bauteils nach Anspruch 7,
**dadurch gekennzeichnet, dass**
es die folgenden Schritte umfasst:
- Herstellung auf einem Substrat oder einem Spiegel (20) eines Stapels, welcher nacheinander eine n-dotierte InP-Schicht (2), eine Schicht (3) aus einem aktiven Material und eine p-dotierte InP-Schicht (4) enthält;
- Ätzen dieser beiden Schichten, um auf der n-dotierten InP-Schicht eine Echoanzeige herzustellen;
- Epitaxie auf der Echoanzeige und der n-dotierten InP-Schicht einer p-dotierten InP-Schicht (6) mit einer dazwischen angeordneten InAlAs-Schicht (26), und anschließende Epitaxie einer p-dotierten GaInAs-Schicht (7);
- Ätzung dieser drei Schichten im Abstand zu der Echoanzeige bis zu der n-dotierten InP-Schicht;
- Durchführung einer seitlichen selektiven Oxidation durch feuchten chemischen Angriff der InAlAs-Schicht, um dadurch in dieser Schicht die kreisförmige Barriere herzustellen;
- Auftrag einer metallischen Schicht (10) auf das Bauteil;
- Ätzen in der metallischen Schicht und der GaInAs-Schicht einer kreisförmigen Öffnung gegenüber der Echoanzeige und Einsetzen eines Spiegels (12) in diese Öffnung; und
Auftrag einer metallischen Schicht (18) an der Unterseite des Bauteils.

## Claims

1. A vertical-cavity surface-emitting laser component operating at a wavelength lying in the range 1.3 µm to 1.55 µm, the component comprising a layer (3) of active material having an injection zone of width (d) that is smaller than the width of the component, said zone emitting radiation when an electrical current is injected therein, the component also comprising an amplifying medium for amplifying the radiation and two mirrors (12, 16; 12, 20) that are reflective at the emission wavelength and disposed respectively above and below the amplifying medium, characterized in that the amplifying medium includes a circular barrier (8; 26) extending facing the active material (3), said barrier opposing the passage of current and defining a current-passing channel in its center facing the injection zone, said channel being of a width (c) that is smaller than the width (d) of the injection zone.

2. A component according to claim 1, characterized in that it comprises on a substrate (5) or on a mirror (20), a stack of the following successive layers:
· an n-doped InP layer (2);
· an active material layer (3);
· a p-doped InP layer (4), the latter two layers forming a mesa on the n-doped InP layer;
· a p-doped InP layer (6) covering the mesa and the n-doped InP layer, and including the circular barrier (8);
· a p-doped GalnAs layer (7); and
· a metal contact (10), the latter two layers presenting a circular opening facing the mesa and having a mirror (12) deposited therein, the component presenting another metal contact (18) on its bottom face.

3. A component according to claim 1, characterized in that it comprises, on a substrate or on a mirror (20), a stack of the following successive layers:
· an n-doped InP layer (2);
· an active material layer (3);
· a p-doped InP layer (4), the latter two layers forming a mesa on the n-doped InP layer;
· a p-doped InP layer (24);
· a p⁺-doped GalnAs layer (7), the latter two layers extending around the mesa on the n-doped InP layer; and
· a metal contact (10),
the GalnAs layer and the metal contact having a circular opening facing the mesa in which a mirror (12) is deposited, the component having another metal contact (18) on its bottom face, the circular barrier (8) extending in the p-doped InP layers.

4. A component according to claim 1, characterized in that it comprises, on a substrate or on a mirror (20), a stack of the following successive layers:
· an n-doped InP layer (2);
· an active material layer (3);
· a p-doped InP layer (4) in which the circular barrier (8) extends;
· a GalnAs layer (24), the latter three layers forming a mesa on the n-doped InP layer;
· a polyimide layer (22) extending over the n-doped InP layer around the mesa; and
· a metal contact (10) extending over the mesa and the polyimide layer, the GalnAs layer and the metal contact having a circular opening facing the mesa and of a width that is smaller than that of the mesa, a mirror (12) being deposited therein, the component having another metal contact (18) on its bottom face.

5. A component according to claim 1, characterized in that it comprises, on a substrate or on a mirror, a stack of the following successive layers:
· an n-doped InP layer (2);
· an active material layer (3);
· a p-doped InP layer (4), the latter two layers forming a mesa on the n-doped InP layer;
· a p-doped InP layer (6) covering the mesa and the n-doped InP layer, an InAlAs layer (26) including the circular barrier being interposed therein;
· a p-doped GalnAs layer (7); and
· a metal contact (10),
the latter two layers presenting a circular opening facing the mesa and in which a mirror is disposed, the component also having another metal contact (18) on its bottom face.

6. A component according to claim 1, characterized in that it includes, on a substrate or a mirror, a stack of the following successive layers:
· an n-doped InP layer (2);
· an active material layer (3);
· a p-doped InP layer (4) in which an InAlAs layer (26) including the circular barrier is interposed, the p-doped InP layer, the InAlAs layer, and the active material layer forming a mesa on the n-doped InP layer;
· a p-doped InP layer (24);
· a p⁺-doped GalnAs layer (7), the latter two layers extending around the mesa on the n-doped InP layer; and
· a metal contact (10),
the GalnAs layer and the metal contact having a circular opening facing the mesa and in which a mirror (12) is despoiled, the component having another metal contact (18) on its bottom face.

7. A component according to claim 1, characterized in that it includes, on a substrate or a mirror (20), a stack of the following successive layers:
· an n-doped InP layer (2);
· an active material layer (3);
· a p-doped InP layer (4) having an InAlAs layer (26) including the circular barrier interposed therein;
· a GalnAs layer (24), the active material layer, the p-doped InP layer, the InAlAs layer, and the GalnAs layer forming a mesa on the n-doped InP layer;
· a polyimide layer (22) extending over the n-doped InP layer around the mesa; and
· a metal contact (10) extending over the mesa and the polyimide layer, the GalnAs layer and the metal contact having a circular opening facing the mesa and of a width that is smaller than that of the mesa, a mirror being deposited therein, the component having another metal contact (18) on its bottom face.

8. A component according to any one of claims 1 to 7, characterized in that the stack is deposited on an n-doped InP substrate (5), a metal contact (18) extending over the bottom face of said substrate, the substrate having a cavity whose end wall extends facing the active material (3) and in the vicinity thereof, a mirror (16) being deposited in said cavity.

9. A component according to any one of claims 1 to 7, characterized in that the stack is deposited on a semiconductor mirror (20), a metal contact (18) extending over the bottom face of said mirror.

10. A method of fabricating a component according to claim 2, characterized in that it comprises the steps consisting in:
· making on a substrate (5) or on a mirror (20) a stack comprising in succession an n-doped InP layer (2), an active material layer (3), and a p-doped InP layer (4);
· etching the latter two layers to form a mesa on the n-doped InP layer;
· epitaxially growing on the mesa and on the n-doped InP layer, a p-doped InP layer (6) and then a p-doped GalnAs layer (7);
· depositing a photosensitive resin thereon;
· placing a mask facing the top of the mesa and having a width that is smaller than the width of the mesa;
· bombarding the component with H⁺ ions so as to make a circular barrier (8) in the p-doped InP layer covering the mesa;
· removing the mask;
· depositing a metal layer (10) on the component;
· etching a circular opening that faces the mesa in the metal layer and in the GalnAs layer, and depositing a mirror (12) in said opening; and
· depositing a metal layer (18) on the bottom face of the component.

11. A method of fabricating a component according to claim 3, characterized in that it comprises the steps consisting in:
· making on a substrate or on a mirror (20) a stack comprising in succession an n-doped InP layer (2), an active material layer (3), a p-doped InP layer (4), and a GalnAs layer;
· etching the latter three layers to form a mesa on the n-doped InP layer;
· depositing a regrowth mask on the top of the mesa;
· performing localized epitaxial growth around the mesa of a p-doped InP layer (24), then of a p⁺-doped GalnAs layer (7);
· removing the mask;
· depositing a photosensitive resin on the component;
· placing a mask to face the top of the mesa and of a width that is smaller than the width of the mesa;
· bombarding the component with H⁺ ions to form the circular barrier in the p-doped InP layers;
· removing the mask;
· depositing a metal layer (10) on the component;
· etching a circular opening extending facing the mesa in the metal layer and the GalnAs layer, and depositing a mirror (12) in said opening; and
· depositing a metal layer (18) on the bottom face of the component.

12. A method of fabricating a component according to claim 4, characterized in that it comprises the steps consisting in:
· making on a substrate or a mirror (20) a stack comprising in succession an n-doped InP layer (2), an active material layer (3), a p-doped InP layer (4), and a layer (25) of GalnAs;
· etching the latter three layers to form a mesa on the n-doped InP layer;
· depositing a layer (22) of polyimide to cover the mesa and the n-doped InP layer;
· reactively etching the polyimide layer to uncover the top of the mesa;
· depositing a photosensitive resin on the component;
· depositing a mask facing the top of the mesa, the width of the mask being smaller than the width of the mesa;
· bombarding the component with H⁺ ions so as to make a circular barrier (8) in the p-doped InP layer;
· removing the mask;
· depositing a metal layer (10) on the component;
· etching a circular opening extending facing the mesa and of a width smaller than the width of the mesa in the GalnAs layer and in the metal layer, and depositing a mirror (12) in said opening; and
· depositing a metal layer (18) on the bottom face of the component.

13. A method of fabricating a component according to claim 5, characterized in that it comprises the steps consisting in:
· making, on a substrate or on a mirror (20) a stack comprising in succession an n-doped InP layer (2), an active material layer (3), and a p-doped InP layer (4);
· etching the latter two layers to form a mesa on the n-doped InP layer;
· epitaxially growing a p-doped InP layer (6) on the mesa and the n-doped InP layer, with an InAlAs layer (26) being interposed therein, and then epitaxially growing a p-doped GalnAs layer (7);
· etching the latter three layers at a distance from the mesa down to the n-doped InP layer;
· performing selective lateral oxidation by wet chemical etching of the InAlAs layer so as to form the circular barrier therein;
· depositing a metal layer (10) on the component;
· etching a circular opening that extends facing the mesa in the metal layer and the GalnAs layer, and depositing a mirror (12) in said opening; and
· depositing a metal layer (18) on the bottom face of the component.

14. A method of fabricating a component according to claim 6, characterized in that it comprises the steps consisting in:
· making, on a substrate or on a mirror (20), a stack comprising in succession an n-doped InP layer (2), an active material layer (3), a p-doped InP layer (4) having an InAlAs layer (26) interposed therein, and a GalnAs layer;
· etching the last four layers to form a mesa on the n-doped InP layer;
· performing selective lateral oxidation by wet chemical etching of the InAlAs layer so as to form the circular barrier therein;
· depositing a regrowth mask to cover the top of the mesa;
· performing localized epitaxial growth around the mesa of a layer (24) of semi-insulating InP, and then of a layer (7) of p⁺-doped GalnAs;
· removing the mask and the layer of GalnAs from the mesa;
· etching a circular opening extending facing the mesa in the metal layer and in the GalnAs layer, and depositing a mirror (12) in said opening; and
· depositing a metal layer (18) on the bottom face of the component.

15. A method of fabricating a component according to claim 7, characterized in that it comprises the steps consisting in:
· making, on a substrate or on a mirror (20), a stack comprising in succession an n-doped InP layer (2), an active material layer (3), a p-doped InP layer (4) having an InAlAs layer (26) interposed therein, and a GalnAs layer;
· etching the latter four layers to form a mesa on the n-doped InP layer;
· performing selective lateral oxidation by wet chemical etching of the InAlAs layer to form the circular barrier therein;
· depositing a polyimide layer (22) to cover the mesa and the n-doped InP layer;
· performing reactive etching of the polyimide layer to uncover the top of the mesa;
· depositing a metal layer (10) on the component;
· etching a circular opening extending facing the mesa in the GalnAs layer and in the metal layer, the width of the opening being smaller than the width of the mesa, and depositing a mirror (12) in said opening; and
· depositing a metal layer (18) on the bottom face of the component.
